# EUROPÄISCHE PATENTSCHRIFT

(11) **EP 4 018 205 B1**
(45) Veröffentlichungstag und Bekanntmachung des Hinweises auf die Patenterteilung: **02.10.2024**
(21) Anmeldenummer: 20764317.2
(22) Anmeldetag: 20.08.2020
(51) Int. Cl.: G01P 15/08, G01P 15/135, G06M 1/10

(54) **PASSIVER MIKROMECHANISCHER ZÄHLER**
PASSIVE MICROMECHANICAL COUNTER
COMPTEUR MICROMÉCANIQUE PASSIF

(30) Priorität: 22.08.2019 DE 102019122671
(43) Veröffentlichungstag der Anmeldung: 29.06.2022
(73) Patentinhaber: Ruhr-Universität Bochum, 44801 Bochum (DE)
(72) Erfinder: SCHMITT, Philip, 44801 Bochum (DE); HOFFMANN, Martin, 44879 Bochum (DE)
(74) Vertreter: Michalski Hüttermann & Partner Patentanwälte mbB
(86) Internationale Anmeldenummer: PCT/EP2020/073425
(87) Internationale Veröffentlichungsnummer: WO 2021/032859

(56) Entgegenhaltungen:
- CN-C- 100 542 034
- DE-T2- 69 735 627
- US-A1- 2013 192 372
- US-A1- 2015 022 053
- ROBERT M PROIE ET AL: "Piezoelectric micro-scale mechanical computing system", MICRO ELECTRO MECHANICAL SYSTEMS (MEMS), 2012 IEEE 25TH INTERNATIONAL CONFERENCE ON, IEEE, 29 January 2012 (2012-01-29), pages 587 - 590, XP032137304, ISBN: 978-1-4673-0324-8, DOI: 10.1109/MEMSYS.2012.6170243
- BELSITO LUCA ET AL: "Fabrication of high-resolution strain sensors based on wafer-level vacuum packaged MEMS resonators", SENSORS AND ACTUATORS A: PHYSICAL, ELSEVIER BV, NL, vol. 239, 12 January 2016 (2016-01-12), pages 90 - 101, XP029415369, ISSN: 0924-4247, DOI: 10.1016/J.SNA.2016.01.006
- PHILIP SCHMITT ET AL: "A Micromechanical Binary Counter with MEMS-Based Digital-to-Analog Converter", PROCEEDINGS, vol. 2, no. 13, 21 November 2018 (2018-11-21), pages 807, XP055754777, DOI: 10.3390/proceedings2130807
- MEHNER HANNES ET AL: "Passive microsensor for binary counting of numerous threshold events", PROCEEDINGS OF SPIE, IEEE, US, vol. 9517, 20 May 2015 (2015-05-20), pages 95170Z - 95170Z, XP060055561, ISBN: 978-1-62841-730-2, DOI: 10.1117/12.2178726
- HOFFMANN M ET AL: "Non-electrical Sensing and Storing an Alternative to Electrical Energy Harvesting", PROCEDIA ENGINEERING, ELSEVIER BV, NL, vol. 168, 4 January 2017 (2017-01-04), pages 1621 - 1625, XP029874959, ISSN: 1877-7058, DOI: 10.1016/J.PROENG.2016.11.475

## Beschreibung

Die Erfindung betrifft einen passiven mikromechanischen Zähler zum Zählen und Speichern einer Anzahl an mechanischen Impulsen.

Zur Überwachung wichtiger Bauelemente werden in der Regel verschiedene Sensoren und Sensornetzwerke eingesetzt. Äußere Einflüsse wie Temperatureinwirkung oder Beschleunigungen an bestimmten Bauelementen können so kontinuierlich erfasst und elektronisch ausgewertet werden. Eine Echtzeitauswertung von detaillierten Messergebnissen ist vor allem dann wichtig, wenn als Reaktion dieser Messergebnisse ein bestimmtes Ereignis hervorgerufen werden soll.

Häufig genügt es jedoch anstelle einer kontinuierlichen Erfassung eines detaillierten zeitaufgelösten Messwerteverlaufs nur besonders kritische Grenzwertereignisse zu registrieren und zu speichern. Zu solchen Grenzwertüberschreitungen gehören beispielsweise das Überschreiten bestimmter Temperatur-, Dehnungs- oder Beschleunigungsgrenzen. Oft entscheidet die Häufigkeit solcher Ereignisse über die verbleibende Lebensdauer spezifischer Bauelemente. Die Kenntnis über die Anzahl der bisher eingetretenen Grenzwertüberschreitungen erlaubt es bei Wartungsarbeiten stark beanspruchte Bauelemente frühzeitig zu identifizieren und auszutauschen, um so den Ausfall oder die Beschädigung des Gesamtsystems zu vermeiden.

An schwer zugänglichen oder bewegten Bauelementen scheitert die Integration von aktiven Sensoren, die Messwerte kontinuierlich erfassen, oft an der notwendigen Energiezufuhr. Viele Sensoren könnten zwar über Energy Harvesting oder Batterien mit Energie versorgt werden, allerdings müssen diese Art Sensoren dann kostenaufwendig gewartet werden.

Die Druckschrift Philip Schmitt et al: "A Micromechanical Binary Counter with MEMS-Based Digital-to-Analog Converter", Proceedings, 2018, 2, 807, DOI: 10.3390/proceedings2130807 beschreibt einen miniaturisierten mikromechanischen binär Zähler, welcher das Zählen von Schwellwertereignissen, wie das Überschreiten von Temperaturlimits oder starke mechanische Schocks ermöglicht. Ein elektromechanischer Digital-zu-Analogwandler, der in den Zähler integriert ist, wird als Möglichkeit zum elektrischen Auslesen der mechanisch gespeicherten Information präsentiert.

Die Druckschrift Mehner Hannes et al: "Passive microsensor for binary counting of numerous threshold events", Proceedings of Spie, Vol. 9517, 95170Z, DOI: 10.1117/12.2178726 beschreibt einen vollständig integriertes passives Mikrosystem zum binären Zählen von Grenzwertüberschreitungen.

Die Druckschrift Hoffmann M et al: "Non-electrical Sensing and Storing an Alternative to Electrical Energy Harvesting", Procedia Engineering, 168, (2016), 1621-1625, DOI: 10.1016/J.PROENG.2016.11.457 beschreibt zwei nicht-elektrische Beispiele zum Registrieren von Daten, ohne elektrische Energie zu benötigen.

Das Dokument US 2015/022053 A1 betrifft eine Vorrichtung mit einem beweglichen Element mit Zähnen, einem Antriebselement zum Eingriff mit den Zähnen des beweglichen Elements, um das bewegliche Element in einer Bewegungsrichtung in Bewegung zu versetzen, einem Betätigungselement, das in der Lage ist, eine alternierende Bewegung zu erzeugen, um das Antriebselement gemäß mindestens zwei Phasen zu bewegen, d. h. einer Antriebsphase, während der das Antriebselement mit einem Zahn in Eingriff steht und einer Rückstellphase ohne Antrieb, während der das Antriebselement gegenüber dem beweglichen Element verschoben wird, und mit einem ersten Indexelement, das einen ersten Indexfinger umfasst, der zwischen zwei Zähnen zu positionieren ist, und das mit dem Betätigungselement verbunden ist, um das Antriebselement und den ersten Indexfinger gleichzeitig zu bewegen.

Dementsprechend besteht ein Bedürfnis die Anzahl an grenzwertüberschreitenden Ereignissen festzustellen ohne dafür eine elektrische Energieversorgung bereitstellen zu müssen. Demnach ist es die Aufgabe der Erfindung, einen Zähler bereitzustellen, der ohne elektrische Energieversorgung in der Lage ist das Zählen von Grenzwertereignissen zu ermöglichen und ohne elektrische Energieversorgung die gezählte Anzahl zu speichern.

Diese Aufgabe wird durch die Merkmale des unabhängigen Patentanspruchs gelöst. Bevorzugte Weiterbildungen finden sich in den Unteransprüchen.

Erfindungsgemäß wird also ein passiver mikromechanischer Zähler zum Zählen und Speichern einer Anzahl an mechanischen Impulsen umfassend wenigstens eine Speicherzelle bereitgestellt, wobei die Speicherzelle einen Zelleingang, einen Rastmechanismus und eine elektromechanische Codiereinheit umfasst, wobei der Zelleingang dazu ausgeführt ist, den mechanischen Impuls mechanisch an den Rastmechanismus zu übertragen, wobei der Rastmechanismus dazu ausgeführt ist, die Anzahl übertragener mechanischer Impulse mittels seiner diskreten Einrastposition zu speichern, wobei durch Anlegen einer elektrischen Spannung an die elektromechanische Codiereinheit ein elektrisches digitales Signal erzeugbar ist, und wobei das elektrische digitale Signal die diskrete Einrastposition des Rastmechanismus repräsentiert.

Die Grundidee der Erfindung liegt darin, dass der Zähler ohne elektrische Energieversorgung mechanische Impulse zählen und deren Anzahl über den mechanischen Rastmechanismus speichern kann. Die Energie, die zum Zählen und Speichern notwendig ist, wird direkt aus dem mechanischen Impuls gewonnen. Bevorzugt umfasst der mechanische Impuls einen mechanischen Stoß, einen Kraftimpuls, und/oder einen Verschiebungsimpuls. Weiter bevorzugt liegt die Größenordnung des mechanischen Impulses im Bereich von 100 bis 2000 µN, und/oder im Bereich von einer Verschiebung von 1 bis 100 µm des Zelleinganges. Als mechanischer Impuls wird bevorzugt eine Kraft verstanden, die kurzfristig am Zelleneingang wirkt. Der mechanische Impuls wird vom Zelleingang der Speicherzelle aufgenommen und mechanisch an den Rastmechanismus übertragen. Der Rastmechanismus speichert die Anzahl übertragener mechanischer Impulse mittels seiner diskreten Einrastposition. Das Zählen und Speichern erfolgt somit rein mechanisch und es wird folglich keine elektrische Energie benötigt. Dementsprechend handelt es sich um einen passiven Zähler. Bei passiven Zählern stellt das elektrische Auslesen der gespeicherten Anzahl an mechanischen Impulsen eine Herausforderung dar. Erfindungsgemäß wird das Auslesen gelöst indem der Zähler eine elektromechanische Codiereinheit umfasst, die derart ausgestaltet ist, dass durch Anlegen einer elektrischen Spannung an die elektromechanische Codiereinheit ein elektrisches digitales Signal erzeugbar ist, das die diskrete Einrastposition des Rastmechanismus repräsentiert. In anderen Worten benötigt der Zähler erst zum Auslesen des gespeicherten Zählerstandes elektrische Energie bzw. eine elektrische Spannung. Die elektrische Spannung kann beispielsweise während des Auslesevorganges über einen RFID-Tag bereitgestellt werden. Sobald an der elektromechanischen Codiereinheit eine Spannung angelegt wird, wird ein elektrisches digitales Signals erzeugt und bevorzugt ausgegeben. Insbesondere ist zur Erzeugung des elektrischen digitalen Signals keine weitere aufwendige Elektronik, wie beispielsweise einen Analog-Digital-Wandler notwendig. Bevorzugt kann auf aktive elektrische Bauelemente wie Verstärker, Komparatoren, und/oder Transistoren kann verzichtet werden.

Beim Zähler handelt es sich um einen mikromechanischen Zähler. Im Sinne der Erfindung bedeutet dies, dass der Zähler bevorzugt Abmessungen im µm-Bereich bis mm-Bereich aufweist. Bevorzugt sind die äußeren Abmessungen der Speicherzelle kleiner als 2000 µm. Die Abmessungen einer kleinsten Komponente des Zählers, sowie ein kleinster Abstand zwischen den Komponenten des Zählers sind zudem bevorzugt nicht größer als 10 µm. Weiter bevorzugt weist die Speicherzelle eine im Wesentlichen 2-dimensionale Form auf, d.h. die Speicherzelle ist sehr flach. Insbesondere beträgt die Höhe der Speicherzelle nicht mehr als 2 µm bis 100 µm.

Der passive mikromechanische Zähler lässt sich mit einem Energiewandler kombinieren, um verschiedene Grenzwertüberschreitungen eines physikalischen Ereignisses abzudecken. Der Energiewandler kann das zu zählende physikalische Ereignis in mechanische Energie in Form des mechanischen Impulses umwandeln. Die Anzahl mechanischer Impulse kann dann vom Zähler gezählt und gespeichert werden.

Ein derart aufgebauter passiver elektromechanische Zähler eignet sich insbesondere für die autarke Überwachung von Grenzwertüberschreitungen, beispielsweise Temperatur-, Strom, Spannungs-, und/oder Beschleunigungsüberschreitungen. Bevorzugt ist der Zähler für die Wartung von schwerzugänglichen Bauelementen, an denen entsprechende Grenzwerte auftreten können, geeignet. Weiterhin ist der Zähler bevorzugt dazu geeignet die dynamische Beanspruchung von Bauwerken zu überwachen. Die Anzahl an mechanischen Impulsen kann beispielsweise Aufschluss über die Nutzung und/oder den Verschleiß der zu überwachenden Bauwerke liefern. Des Weiteren ist der Zähler dafür geeignet, schwingungsbeanspruchte Bauelement, wie beispielsweise Tragflächen von Flugzeugen, zu überwachen. Die Dauerfestigkeit und somit die Lebensdauer von Werkstoffen hängt im Wesentlichen sowohl von der Häufigkeit der wechselnden Beanspruchung als auch von deren Amplitude ab. Der Zähler kann alleine oder bevorzugt in Kombination mit einem entsprechenden Energiewandler an den zu überwachenden Stellen des schwingungsbeanspruchten Bauelementes angebracht werden, wo er die Lebensdauer der entsprechenden Komponente überwacht.

In einer bevorzugten Weiterbildung der Erfindung ist vorgesehen, dass der Zelleingang dazu ausgeführt ist, den mechanischen Impuls in Form einer translatorischen oder rotatorischen Bewegung an den Rastmechanismus zu übertragen. Insbesondere ist die translatorische oder rotatorische Bewegung in ihrer Größe definiert und beschränkt. Dies bedeutet, dass auch bei einem starken mechanischen Impuls die translatorische oder rotatorische Bewegung den definierten Wert nicht übersteigt. Somit wird der Rastmechanismus vor zu hohen mechanischen Impulsen geschützt. Bevorzugt beträgt die translatorische Bewegung des Zelleinganges zwischen 1 und 100 µm. Weiter bevorzugt beträgt die rotatorische Bewegung des Zelleinganges zwischen 0,2 und 0,5 µrad. Weiterhin bedeutet dies auch, dass ein schwacher mechanischer Impuls, solange er über einem bestimmten Grenzwert liegt, die gleiche translatorische oder rotatorische Bewegung auslöst wie ein starker Impuls. Bevorzugt liegt der Grenzwert des mechanischen Impuls ab dem eine translatorische oder rotatorische Bewegung gezählt wird zwischen 0.5 µm und 100 µm bzw. zwischen 50 µN und 2000 µN. Besonders bevorzugt liegt der Grenzwert des mechanischen Impuls ab dem eine translatorische oder rotatorische Bewegung gezählt wird bei mindestens 1 µm bzw. 100 µN, +/- 10 %. Insbesondere ist der Zelleingang derart ausgeführt, dass der Zelleingang sich bezogen auf den Rastmechanismus translatorisch vor und zurückbewegen kann. Alternativ ist der Zelleingang derart ausgeführt, dass der Zelleingang sich rotatorisch hin und her drehen kann. Weiter bevorzugt führt der mechanische Impuls zu einer Auslenkung des Zelleingangs.

In Zusammenhang mit dem Zählen des mechanischen Impulses ist in einer bevorzugten Weiterbildung der Erfindung vorgesehen, dass der Rastmechanismus dazu ausgeführt ist bei jedem vom Zelleingang übertragenen mechanischen Impuls seine diskrete Einrastposition zu verändern. Somit korreliert die absolute Einrastposition des Rastmechanismus mit der Anzahl übertragener mechanischer Impulse. Der Rastmechanismus bildet demnach den eigentlichen Zahlenspeicher der Speicherzelle. Eingehende mechanische Impulse am Zelleneingang werden mit Hilfe des Rastmechanismus mechanisch gezählt. Bevorzugt wird die Auslenkung des Zelleingangs gezählt. Weiter bevorzugt wird die Auslenkung des Zelleingangs gezählt, wenn der Zelleingang sich wieder in seine Ausgangslage zurückbewegt. Weiter bevorzugt ist vorgesehen, dass mit der sich veränderten diskreten Einrastposition ein Abstand zwischen dem Zelleingang und dem Rastmechanismus verringert wird. Mit zunehmendem Zählerstsand der Speicherzelle rückt der Zelleingang also näher an den Rastmechanismus heran und/oder der Rastmechanismus rückt näher an den Zelleingang heran.

Insbesondere ist in einer weiteren bevorzugten Weiterbildung der Erfindung vorgesehen, dass eine Kraft zum Verändern der diskreten Einrastposition unabhängig von der diskreten Einrastposition ist. Die Kraft zum Verändern der diskreten Einrastposition des Rastmechanismus - auch als Schaltkraft bezeichnet - ist somit unabhängig vom Zählerstand der Speicherzelle. Dies hat insbesondere den Vorteil, dass der Grenzwert des mechanischen Impulses ab dem der Zelleingang die translatorische oder rotatorische Bewegung auslöst gleich bleibt und sich nicht mit der Anzahl an gespeicherten Grenzwertüberschreitungen ändert. Somit ist ein verlässliches Zählen möglich.

Abhängig von den Ausmaßen der Speicherzelle weist die Speicherzelle eine unterschiedliche Speicherkapazität auf. Die Speicherkapazität definiert wie viele mechanische Impulse von der Speicherzelle registriert und deren Anzahl gespeichert werden kann. Gemäß einer bevorzugten Weiterbildung der Erfindung ist vorgesehen, dass die Anzahl diskreter Einrastpositionen des Rastmechanismus die Speicherkapazität der Speicherzelle definiert. Somit hängt die Anzahl möglicher zu zählender mechanischer Impulse direkt von der Anzahl an Einrastpositionen des Rastmechanismus ab. Wenn der Rastmechanismus der Speicherzelle beispielsweise 32 disktrete Einrastposition aufweist, beträgt die Speicherkapazität der Speicherzelle in Bit ausgedrückt 5 Bit (2⁵ = 32). Somit kann eine Speicherzelle grundsätzlich je nach Dimensionierung ein beliebig langes Datenwort speichern. Bevorzugt beträgt die Speicherkapazität der Speicherzelle wenigstens 3 Bit, d.h. der Rastmechanismus weist also wenigstens 8 diskrete Einrastpositionen auf.

In Zusammenhang mit der Ausgestaltung des Rastmechanismus ist gemäß einer bevorzugten Weiterbildung der Erfindung vorgesehen, dass der Rastmechanismus einen Läufer oder einen Rotor, sowie eine Gegenraste umfasst, wobei der Läufer oder der Rotor mittels Rastzähnen an der Gegenraste in der diskreten Einrastposition einrastbar sind. Wie bereits erwähnt ist der Zelleingang dazu ausgeführt, den mechanischen Impuls in Form einer translatorischen oder rotatorischen Bewegung an den Rastmechanismus zu übertragen. Grundsätzlich sind also zwei Formen zu unterscheiden. Im Falle einer translatorischen Bewegung umfasst der Rastmechanismus einen Läufer der mittels Rastzähnen an der Gegenraste einrastbar ist. Alternativ, im Falle einer rotatorischen Bewegung umfasst der Rastmechanismus einen Rotor, der mittels der Rastzähne an der Gegenraste in der diskreten Einrastposition einrastbar ist. Bevorzugt umfassen der Läufer sowie der Rotor und die Gegenraste Rastzähne. Weiter bevorzugt sind am Läufer bzw. am Rotor in festgelegten Abständen die Rastzähne angeordnet. Besonders bevorzugt umfasst der Rastmechanismus den Läufer. Weiter bevorzugt weist der Läufer eine lineare Form auf, wobei die Rastzähne als Vorsprünge entlang des Läufers ausgebildet sind. Jeder Rastzahn des Läufers und/oder jede Rastzahnpaarung des Läufers und der Gegenraste definieren somit die diskrete Einrastposition des Rastmechanismus. Die diskrete Einrastposition, die der Läufer zur Gegenraste einnehmen kann, repräsentiert den gespeicherten Zählerstand der Speicherzelle. Die Gegenraste ist bevorzugt mit dem Zelleingang verbunden und überträgt somit die translatorische Bewegung des Zelleinganges. Weiter bevorzugt gleitet die Gegenraste bei der translatorischen Bewegung ohne wesentlichen Kraftaufwand über die Rastzähne des Läufers. Sobald ein Formschluss der Rastzähne des Läufers und der Gegenraste erreicht wird, wird die Kraft an den Läufer übertragen, so dass die diskrete Einrastposition verändert wird.

Gemäß einer weiteren bevorzugten Weiterbildung der Erfindung umfasst der Rastmechanismus einen Haltemechanismus, der derart ausgestaltet ist, dass der Läufer nur entlang einer axialen Richtung verschiebbar ist, oder dass der Rotor nur entlang einer Drehrichtung drehbar ist. Der Haltemechanismus sorgt also dafür, dass sich der Läufer entlang seiner axialen Bewegungsrichtung nur in eine Richtung verschieben lässt, indem er Bewegungen in die entgegengesetzte Richtung blockiert. Alternativ sorgt der Haltemechanismus dafür, dass sich der Rotor entlang seiner Drehrichtung nur in eine Richtung drehen lässt, indem er Drehungen in die entgegengesetzte Drehrichtung blockiert. Somit fixiert der Haltemechanismus den Läufer bzw. Rotor in seiner aktuell erreichten diskreten Einrastposition. So kann innerhalb des Rastmechanismus kein rückwärtszählen stattfinden. Der Haltemechanismus stellt bevorzugt auch das Vorwärtszählen des Rastmechanismus sicher, da sich ohne Haltemechanismus ansonsten der Läufer mit dem Zelleingang mitbewegen könnte. Bevorzugt umfasst auch der Haltemechanismus Rastzähne. Demnach basiert die Wirkungsweise des Haltemechanismus bevorzugt auf Formschluss. Alternativ sind andere Formen des Haltemechanismus wie beispielsweise Greifer oder ein Haltemechanismus, der auf Reibung basiert, möglich.

In Zusammenhang mit dem Auslesen des gespeicherten Zählerstandes, ist gemäß einer bevorzugten Weiterbildung der Erfindung vorgesehen, dass die elektromechanische Codiereinheit Kontaktelektroden und Gegenelektroden umfasst, wobei die diskrete Einrastposition des Rastmechanismus mittels der räumlichen Anordnung der Kontaktelektroden zu den Gegenelektroden ermittelbar ist. Die Aufgabe der elektromechanischen Codiereinheit besteht darin, die diskrete Einrastposition des Rastmechanismus zu digitalisieren, also der jeweiligen Läuferposition einen elektrischen Zahlencode zuzuordnen. Grundsätzlich kann es sich dabei um einen Zahlencode eines beliebigen Zahlensystems handeln, also beispielsweise um einen binären Zahlencode, um einen dezimalen Zahlencode oder um einen hexadezimalen Zahlencode. Bevorzugt ist allerdings, dass die Anzahl an diskreten Einrastpositionen des Rastmechanismus der Speicherzelle jeweils einem Vielfachen von der Basis des gewählten Zahlensystems entspricht. Soll beispielsweise in einem Dezimalsystem gezählt werden, so entspricht die Anzahl an diskreten Einrastposition des Rastmechanismus bevorzugt einem Vielfachen von 10. Besonders bevorzugt handelt es sich beim Zahlencode um einen binären Zahlencode, das heißt die elektromechanische Codiereinheit ordnet der diskreten Einrastposition des Rastmechanismus einen elektrischen binären Zahlencode zu. Dies hat den Vorteil, dass eine einzelne Speicherzelle relativ klein sein kann, da die Anzahl an diskreten Einrastpositionen des Rastmechanismus bevorzugt nur jeweils ein Vielfaches von Zwei ist. Besonders bevorzugt ist die elektromechanische Codiereinheit also derart ausgestaltet, dass durch Anlegen einer elektrischen Spannung an die elektromechanische Codiereinheit ein elektrisches binäres Signal erzeugbar ist, das die diskrete Einrastposition des Rastmechanismus repräsentiert.

Das Digitalisieren der diskreten Einrastposition des Rastmechanismus wird gemäß der bevorzugten Weiterbildung erreicht, indem die diskrete Einrastposition des Rastmechanismus mittels der räumlichen Anordnung der Kontaktelektroden zu den Gegenelektroden ermittelbar ist. Bevorzugt umfasst der Läufer also eine geometrische Codierung mit Hilfe der spezifisch angeordneten Kontaktelektroden. In anderen Worten befinden sich die Kontaktelektroden bevorzugt am Läufer gegenüber den Rastzähnen. Die Kontaktelektroden wirken dabei als Schalter. Je Bit, also je Stelle des binären Zahlencodes, der die elektromechanische Codiereinheit der diskreten Einrastposition zuordnet, wird ein Satz an Kontaktelektroden am Läufer mit jeweils einem Satz an Gegenelektroden benötigt. Ein Satz an Kontaktelektroden wird im Folgenden als Bit-Zweige bezeichnet. Bevorzugt weisen die Kontaktelektroden eine zahn- oder fingerförmige Struktur auf. Dabei definiert die Anwesenheit eine Kontaktelektrode am Bit-Zweig bevorzugt eine logische Eins. Die Abwesenheit einer Kontaktelektrode entspricht bevorzugt einer logischen Null. Eine inverse Definition ist grundsätzlich aber ebenfalls möglich.

Gegenüber den Kontaktelektroden am Läufer befinden sich bevorzugt ortsfeste Abtastpunkte in Form der Gegenelektroden. Die Gegenelektroden sind weiter bevorzugt in einem geringen oder überlappenden Abstand zu den Kontaktelektroden am Läufer montiert. Wird der Läufer translatorisch in Laufrichtung verschoben, so stehen sich je nach Position jeweils eine Gegenelektrode und eine Kontaktelektrode oder eben keine Kontaktelektrode gegenüber. Stehen sich Kontaktelektrode und Gegenelektrode eines Bit-Zweigs gegenüber, so entspricht dies für das entsprechende Bit bevorzugt einer logischen Eins. Andernfalls liegt bevorzugt eine logische Null vor. Ein einzelner Bit-Zweig repräsentiert also bevorzugt jeweils eine Stelle der binären Zähl. Somit hängt die Anzahl und Größe der Kontaktelektroden an einem Bit-Zweig von der Position der Stelle der zu repräsentierenden binären Zahl, als auch von der Gesamtgröße der binären Zahl ab.

Hat eine Speicherzelle mit 2ⁿ verschiedenen Rastpositionen eine Speicherkapazität von n-Bit, so werden grundsätzlich auch n Bit-Zweige benötigt. Beispielsweise weist die Speicherkapazität der Speicherzelle 5 Bit auf - es liegen also 32 (2⁵ = 32) diskrete Einrastposition vor. Demnach werden auch 5 Bit-Zweige benötigt. Dabei weist der Bit-Zweig der ersten Stelle, bzw. des nullten Bits, 2ⁿ/2 Kontaktelektroden auf. Im obigen Beispiel sind das also 2⁵/2= 16 Kontaktelektroden. Diese Kontaktelektroden sind derart angeordnet, dass sich gegenüber jedem zweiten Rastzahn des Läufers eine Kontaktelektrode befindet. Der Bit-Zweig des i-ten Bits verfügt dann über 2ⁿ⁻ⁱ/2 Kontaktelektroden. Für das obige Beispiel ergibt sich für die zweite Stelle (bzw. das erste Bit, also i = 1) 2⁵⁻¹/2 = 8. Für den Bit-Zweig der fünften Stelle (bzw. des vierten Bits, also i = 4) ergibt sich 2⁵⁻⁴/2 = 1, als Anzahl Kontaktelektroden. Die diskrete Einrastposition des Rastmechanismus wird so jeweils durch eine einmalige Kombination aus verschiedenen Bit-Belegungen bestimmt.

Die Speicherung der Anzahl mechanische Impulse erfolgt also bevorzugt rein mechanisch und nicht binär, sondern in analoger Form mittels der diskreten Einrastposition. Bevorzugt findet aber beim Auslesen über die elektromechanische Codiereinheit eine binäre Wandlung des Zählerstandes statt, so dass direkt ein binäres elektrisches Signal erzeugbar ist. Es wird also beim Auslesen kein analoges elektrisches Signal erzeugt. Dies hat den Vorteil, dass keine weitere Elektronik notwendig ist. Bevorzugt ist also kein Analog-Digital-Wandel notwendig, um das binäre elektrische Signal zu erzeugen.

Im Zusammenhang mit dem Auslesen ist des Weiteren in einer bevorzugten Weiterbildung der Erfindung vorgesehen, dass die elektromechanische Codiereinheit ein elektrisch Leitfähiges Material umfasst. Bevorzugt umfasst die elektromechanische Codiereinheit dotiertes Silizium. Im Zuge des Auslesens wird bevorzugt an die Codiereinheit eine elektrische Spannung angelegt. Über den Läufer und damit die Kontaktelektroden wird die Spannung je nach Position an die Gegenelektrode übertragen. Dies ist sowohl über einen direkten mechanischen Kontakt zwischen Kontaktelektroden und Gegenelektrode möglich, als auch im kontaktlosen Zustand. Für den Fall des kontaktlosen Zustandes wird bevorzugt anstelle einer Gleichspannung eine hochfrequente Wechselspannung angelegt. Gegenelektrode und Kontaktelektrode bilden dann bevorzugt einen Kondensator der durch die Wechselspannung überbrückt werden kann. Beim Auslesen gelangt das derart erzeugte elektrische Signal bevorzugt in die elektrische Auswerteeinheit. Dabei wird weiter bevorzugt eine parallele, nicht getaktete elektrische Auswertung realisiert. Dies bedeutet, dass alle Bitzustände gleichzeitig ausgelesen werden können. Beispielsweise kann das über die Gegenelektrode übertragene Spannungssignal direkt ausgewertet werden. Im Zuge dessen können an jedem Spannungsabgriff entsprechende Pullup- bzw. Pulldown-Widerstände vorgesehen sein, sodass das Spannungspotential am jeweiligen Spannungsabgriff in jeder Situation klar definiert ist. Besonders bevorzugt ist beim Auslesen ein paralleles digitales elektrisches Signal erzeugbar.

Gemäß einer weiteren bevorzugten Weiterbildung der Erfindung umfasst die Speicherzelle zusätzlich einen Überträger und einen Rückstellmechanismus. Dies hat insbesondere den Vorteil, dass darüber die Speicherzelle mit weiteren Speicherzellen seriell verbindbar ist. Hierrüber lässt sich eine Gesamtspeicherkapazität des passiven mechanischen Zählers drastisch erhöhen.

Bevorzugt ist dabei vorgesehen, dass die Gesamtspeicherkapazität des Zählers dem Produkt der einzelnen Speicherkapazitäten der seriell verschalteten Speicherzellen entspricht. Die Gesamtspeicherkapazität definiert wie viele mechanische Impulse von dem Zähler registriert und deren Anzahl gespeichert werden kann. Wenn beispielsweise eine Speicherzelle eine Speicherkapazität von 5 Bit, also 32 disktrete Einrastposition aufweist, kann durch serielles Verbinden einer solchen Speicherzelle mit einer zweiten solchen Speicherzelle die Gesamtspeicherkapazität des Zählers auf 10 Bit (5 + 5) erhöht werden. Die 10 Bit entsprechen 1024 (2¹⁰ = 1024 oder 32 x 32 = 1024) verschiedenen Möglichkeiten an unterschiedlichen diskreten Einrastpositionen der beiden Speicherzellen zusammengenommen, obwohl die beiden Speicherzellen zusammen nur 64 disktrete Einrastposition (32 + 32 = 64) zur Verfügung stellen. In anderen Worten entspricht die Gesamtspeicherkapazität des Zählers dem Produkt der Speicherkapazitäten der einzelnen Speicherzellen (32 x 32 = 1024). Somit kann der Zähler aus zwei solcher 5 Bit Speicherzellen 1024 mechanische Impulse zählen. Die Anzahl an diskreten Einrastpositionen die der Rastmechanismus einer Speicherzelle aufweist, kann aufgrund der Größe der Speicherzelle limitiert sein. Über den Überträger und den Rückstellmechanismus wird eine serielle Verbindbarkeit der einzelnen Speicherzellen ermöglicht. Dies wirkt sich positiv auf die Systemgröße, die Funktionssicherheit und die Gesamtspeicherkapazität pro Flächeneinheit aus.

In diesem Zusammenhang ist gemäß einer weiteren bevorzugten Weiterbildung der Erfindung vorgesehen, dass der Zähler wenigstens zwei miteinander seriell verschaltete Speicherzellen umfasst, wobei die Speicherzelle jeweils zusätzlich einen Überträger und einen Rückstellmechanismus umfasst. Die zwei Speicherzellen lassen sich über den Überträgers miteinander koppeln. Bevorzugt verbindet der Überträger den Ausgang der ersten Speicherzelle mit dem Zelleneingang der zweiten seriell angeordneten Speicherzelle.

Gemäß einer weiteren bevorzugten Weiterbildung der Erfindung ist der Überträger dazu ausgeführt, bei Erreichen der Speicherkapazität der Speicherzelle den mechanischen Impuls an den Zelleingang der seriell verschalteten weiteren Speicherzelle zu übertragen. Der Überträger ermöglicht also einen Stellenübertrag von einer Speicherzelle zur nächsten. Erreicht eine Speicherzelle ihre Speicherkapazität, so wird der nächste mechanische Impuls, der den Speicher zum Überlaufen bringen würde, bevorzugt über den Überträger an die nächste seriell verbundene Speicherzelle übertragen. Bevorzugt umfasst der Überträger ein formschlüssiges Element. Sobald der Läufer der ersten Speicherzelle die letztmögliche diskrete Einrastposition und damit den letztmöglichen Speicherwert erreicht hat, kommt es also zu einer mechanischen Verbindung zwischen dem formschlüssigen Element und dem Zelleneingang der seriell verbundenen Speicherzelle. Wirkt nun ein weiterer mechanischer Impuls am Zelleingang der ersten Speicherzelle, so kann über die mechanische Verbindung der mechanische Impuls direkt an die nächste Speicherzelle weitergeleitet werden.

Im Zusammenhang mit dem Erreichen der Speicherkapazität der Speicherzelle ist in einer weitere bevorzugten Weiterbildung der Erfindung vorgesehen, dass der Rückstellmechanismus dazu ausgeführt ist bei Erreichen der Speicherkapazität der Speicherzelle durch den mechanischen Impuls die diskrete Einrastposition des Rastmechanismus derart zu verändern, dass sie einem Ausgangszustand entspricht. Die Aufgabe des Rückstellmechanismus besteht also darin, den mechanisch gespeicherten Zahlenwert der Speicherzelle zurück auf den Ausgangszustand zu setzen. Kommt es zu einem Überlauf der Speicherzelle, so werden neben dem Zahlenübertrag zur nächsten Speicherzelle auch die Speicherstellen der übergelaufenen Speicherzelle zurück auf null gesetzt. Der Ausgangszustand der Speicherzelle entspricht somit bevorzugt einem Zählerstand des Zählers von Null. Das Zurückstellen wird bevorzugt vom Rückstellmechanismus realisiert, indem er nach Erreichen der letzten diskreten Einrastposition des Rastmechanismus die Fixierung zwischen den Rastzähnen des Läufers und der Gegenrasten löst, sodass sich der Läufer in seinen Ausgangszustand bewegen kann.

In diesem Zusammenhang ist in einer weiteren bevorzugten Weiterbildung der Erfindung vorgesehen, dass zur Führung des Läufers sowie zur Führung des Zelleneingangs Festkörpergelenke in Form von Führungsfedern genutzt werden. Bevorzugt weisen die Führungsfedern lineare und/oder nichtlineare Federkennlinien auf. Besonders bevorzugt sind nichtlineare Führungsfedern mit konstanter Rückstellkraft. Bei diesen Federn ist die Federkraft für einen gewissen Auslenkungsbereich konstant und steigt nicht mit der weiteren Auslenkung der Feder. Mit Hilfe der nichtlinearen Feder ist die Kraft die zum Inkrementieren des Zählerstandes am Zelleingang aufgebracht werden muss unabhängig vom bereits erreichten Zählerstand an der Speicherzelle.

Nachfolgend wird die Erfindung unter Bezugnahme auf die Zeichnungen anhand eines bevorzugen Ausführungsbeispiels exemplarisch erläutert.

In der Zeichnung zeigen
- Fig. 1: eine schematische Darstellung eines passiven mikromechanischen Zählers, gemäß einer bevorzugten Ausführungsform der Erfindung,
- Fig. 2: eine schematische Darstellung eines Rastmechanismus des Zählers aus Figur 1 zur Illustration des Funktionsprinzips,
- Fig. 3: in Figur 3a) eine schematische Darstellung eines Haltemechanismus des Zählers aus Figur 1 sowie in Figur 3b) eine alternative Ausführungsform des Haltemechanismus,
- Fig. 4: schematisch den Ablauf des direkten Inkrementierens des Zählerstandes des Zählers aus Figur 1,
- Fig. 5: schematisch den Ablauf des indirekten Inkrementierens des Zählerstandes des Zählers aus Figur 1,
- Fig. 6: eine schematische Darstellung einer elektromechanischen Codiereinheit des Zählers aus Figur 1,
- Fig. 7: eine schematische Darstellung eines passiven mikromechanischen Zählers, gemäß einer weiteren bevorzugten Ausführungsform der Erfindung,
- Fig. 8: eine detailliertere Darstellung des Zählers aus Figur 7,
- Fig. 9: eine schematische Darstellung eines Überträgers des Zählers aus Figur 7 und 8 und
- Fig. 10: eine schematische Darstellung eines Rückstellmechanismus des Zählers aus Figur 7 und 8 sowie den schematisch den Ablauf des Rückstellens des Zählerstandes des Zählers aus Figur 7 und 8.

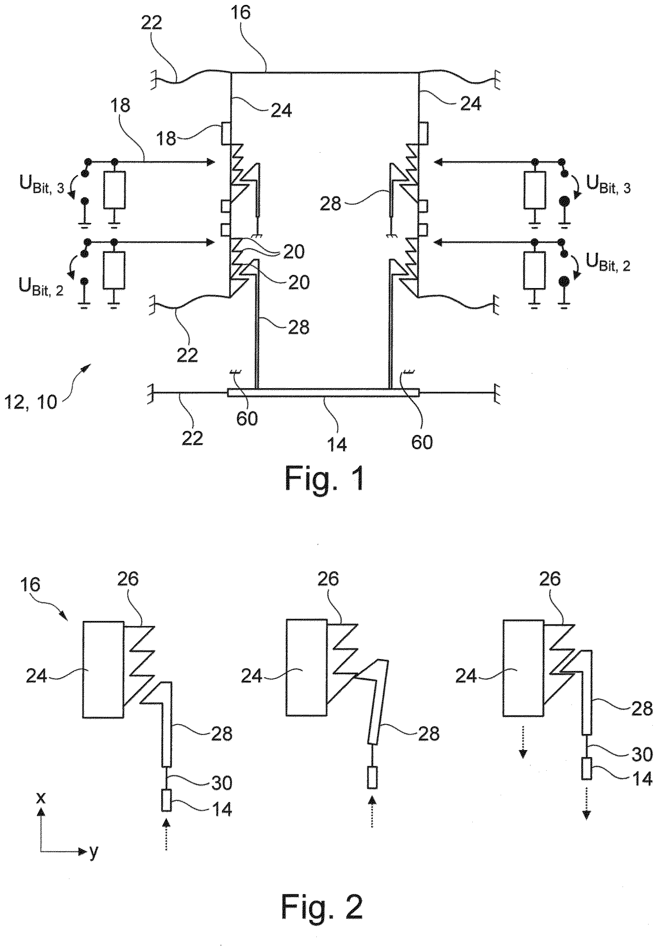

Figur 1 zeigt eine schematische Darstellung einer ersten Ausführungsform eines passiven mikromechanischen Zählers 10. Der passive mikromechanische Zähler 10 umfasst wenigstens eine Speicherzelle 12, wobei die Speicherzelle 12 einen Zelleingang 14, einen Rastmechanismus 16 und eine elektromechanische Codiereinheit 18 umfasst. Der Zelleingang 14 ist dazu ausgeführt, einen mechanischen Impuls mechanisch an den Rastmechanismus 16 zu übertragen, wobei der Rastmechanismus 16 dazu ausgeführt ist, die Anzahl übertragener mechanischer Impulse mittels seiner diskreten Einrastposition 20 zu speichern. Durch Anlegen einer elektrischen Spannung an die elektromechanische Codiereinheit 18 lässt sich ein elektrisches digitales Signal erzeugen, das die diskrete Einrastposition 20 des Rastmechanismus 16 repräsentiert.

Figur 1 zeigt eine Ausführungsform der Erfindung, bei der die einzelne Speicherzelle 12 den Rastmechanismus 16, den Zelleneingang 14, die elektromechanischen Codiereinheit 18 und mehrere nichtlinearen Festkörperführungen 22 in Form von Festkörpergelenken umfasst. Weiterhin zeigt Figur 1, dass die Speicherzelle 12 symmetrisch aufgebaut ist, also jeweils von fast jedem Bauelement zwei zueinander spiegelbildlich angeordnete Paare umfasst. Der Rastmechanismus 16 ist bei der vorliegenden Ausführungsform U-förmig ausgestaltet, wobei die beiden Schenkel der U-Form durch zwei Läufer 24 ausgebildet werden. Der Zelleneingang 14 überträgt den mechanischen Impuls am Eingang der Speicherzelle 12 an den Rastmechanismus 16 in Form einer festgelegten und beschränkten Verschiebung. Im Ausführungsbeispiel handelt es sich dabei um eine translatorische Vor- und/oder Zurückbewegung des Zelleneinganges 14, die durch einen Stopper 60 begrenzt wird.

Figur 2 zeigt einen Ausschnitt des Rastmechanismus 16 der Speicherzelle 12 aus Figur 1. Der Rastmechanismus 16 ist der eigentliche Zahlenspeicher der Speicherzelle 12. Der Rastmechanismus umfasst den Läufer 24 an dem in festgelegten Abständen Rastzähne 26 angeordnet sind. Als Gegenkomponente zu den Rastzähnen 26 umfasst der Rastmechanismus 16 eine Gegenraste 28. Die Gegenraste 28 ist im vorliegenden Ausführungsbeispiel über eine Biegefeder 30 mit dem Zelleneingang 14 verbunden. Somit ist die Gegenraste 28 für Auslenkungen in y-Richtung flexibel gelagert, aber steif für Auslenkungen in x-Richtung. Die Gegenraste 28 gleitet im Wesentlichen ohne großen Kraftaufwand über die Rastzähne 26 des Läufers 24. Sobald ein Formschluss von Rastzahn 26 und Gegenraste 28 erreicht wird, wird die Kraft vom Zelleingang 14 in x-Richtung an den Läufer 24 übertragen.

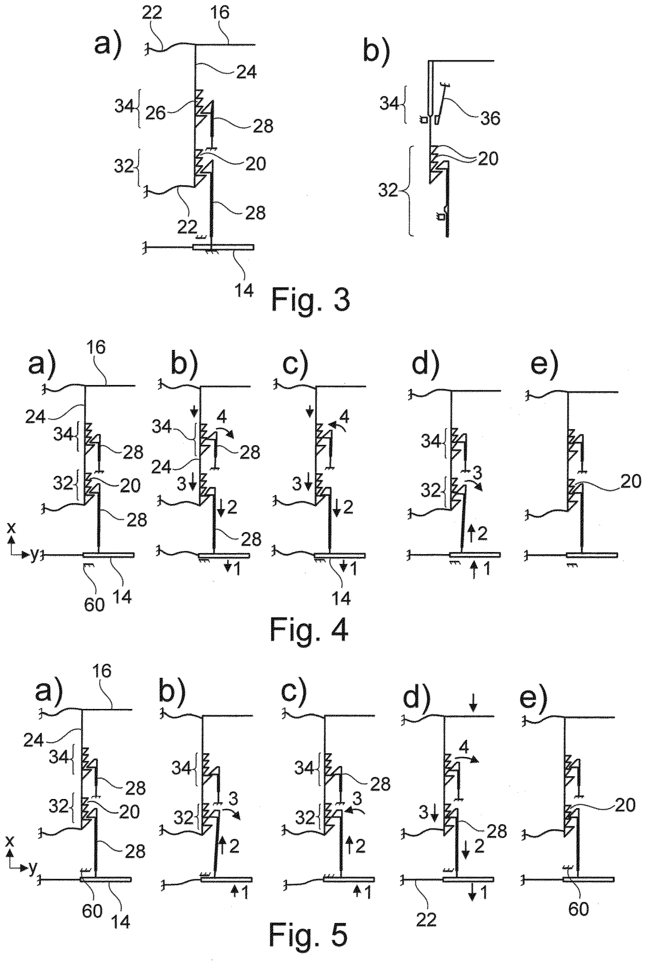

Figur 3a) zeigt einen weiteren Ausschnitt des Rastmechanismus 16 der Speicherzelle 12 aus Figur 1. Der Rastmechanismus 16 teilt sich weiterhin auf in einen Inkrementierer 32 und einen Haltemechanismus 34. Der Haltemechanismus 34 wirkt wie eine mechanische "Diode". Er sorgt dafür, dass sich der Läufer 24 entlang seiner uniaxialen Bewegungsrichtung nur in eine Richtung verschieben lässt, indem er Bewegungen in die entgegengesetzte Richtung blockiert. Somit fixiert der Haltemechanismus 34 den Läufer 24 in seiner aktuell erreichten diskreten Einrastposition 20 während über den Inkrementierer 32 gegebenenfalls eine Kraft in Richtung der blockierten Richtung auf den Läufer 24 übertragen wird. Ohne Haltemechanismus 34 ist in der vorliegenden Ausführungsform kein Inkrementieren des Zählers möglich, da sich der Läufer 24 sonst stets mit dem Zelleingang 14 mitbewegen würde. Der Haltemechanismus 34 basiert in Figur 3a) auf Formschluss und weist dafür ebenfalls Rastzähnen 26 auf. Figur 3b) zeigt schematisch eine alternative Ausführungsform des Haltemechanismus 34 in Form eines Greifers 36 bei der der Läufer 24 anstelle eines Formschlusses über Kraftschluss fixiert wird.

Beim Inkrementierer 32 handelt es sich um eine Paarung aus Rastzähnen 26 des Läufers 24 und Gegenraste 28. Die Rastzähne 26 befinden sich am Läufer 24. Sie definieren die diskreten Einrastpositionen 20, die der Läufer 24 einnehmen kann. Der Läufer 24 ist über das Festkörpergelenk 22 so aufgehängt, dass er uniaxial translatorisch in x-Richtung verschiebbar ist. Die Rückstellkräfte der Festkörpergelenke 22 sind derart ausgelegt, dass sie stets konstant und unabhängig von der Position des Läufers 24 wirken.

Figuren 4 und 5 zeigen schematisch den Ablauf zweier Arten des Inkrementierens des Zählerstandes des Zählers 10. Der Zählerstand einer Speicherzelle 12 kann sowohl direkt (Figur 4) als auch indirekt (Figur 5) inkrementiert werden. Beim direkten Inkrementieren wird die mechanische Energie des mechanischen Impulses unmittelbar zum Zählen genutzt. Die Inkrementierung des Zählerstandes findet dann zeitgleich mit der Vorwärtsbewegung des Zelleneingangs 14 statt. Beim indirekten Inkrementieren wird die Energie des mechanischen Impulses zunächst über eine Feder zwischengespeichert. Zur Inkrementierung des Zählerstandes kommt es dann erst, wenn der mechanische Impuls abklingt und sich der Zelleneingang 14 zu seiner Ursprungsposition zurückbewegt.

Figur 4 zeigt den Schaltablauf beim direkten Inkrementieren: Wird zunächst am Zelleingang 14 ein mechanische Impuls ↓1 eingeleitet (Fig. 4b) wird diese Verschiebung unmittelbar über die Gegenraste 28, ↓2 an den Läufer 24 übertragen ↓3, sodass dieser ebenfalls ausgelenkt wird. Gleichzeitig wird am Haltemechanismus 34 die Fixierung des Läufers 24 gelöst, indem die Gegenrase 28 des Haltemechanismus 34 über die zugehörigen Rastzähne 26 gleitet ↶4.Wird der Zelleneingang 14 noch weiter bis zu seiner Endposition ausgelenkt (Figur 4c) so überwindet die Gegenraste 28 am Haltemechanismus 34 den zugehörigen Rastzahn 26, ↶4. Bewegt sich nun der Zelleneingang 14 wieder zurück zu seiner initialen Position (Figur 4d) ↑1 wird die Gegenraste 28 des Inkrementierers 32 über den nächsten zugehörigen Rastzahn 26 geschoben ↑2, ↷3. Der Inkrementierungsprozess ist damit wie in Figur 4e) gezeigt abgeschlossen.

Figur 5 zeigt den Schaltablauf beim indirekten Inkrementieren: Auch hier wird zunächst der Zelleneingang 14 ausgelenkt (Figur 5b), jedoch im Vergleich zu Figur 4 in die entgegengesetzte Richtung ↑1. Die Verschiebung ↑1 wird unmittelbar vom Zelleneingang 14 an die Gegenraste 28 des Inkrementierers 32 übertragen ↑2. Die Gegenraste 28 des Intrementieres 32 gleitet schließlich über den nächsten zugehörigen Rastzahn 26 am Läufer 24, ↷3, wie in Figur 5b) gezeigt. Der Läufer 24 an sich wurde bis zu diesem Zeitpunkt noch nicht verschoben, da der Haltemechanismus 34 den Läufer 24 fixiert (Figur 5c). Erst beim Zurückbewegen des Zelleneingangs 14 zur initialen Position (Figur 5d), ↓1 wird der Läufer 24 über die Gegenraste 28 des Inkrementieres 32 nach unten gezogen ↓2↓3. Die notwendige Energie zum Zurückstellen des Zelleneingangs 14 liefert dabei die Rückstellfeder 22 des Zelleneingangs 14. Während nun der Läufer 24 nach unten verschoben wird ↓3, gleitet die Gegenraste 28 des Haltemechanismus 34 über den nächsten zugehörigen Rastzahn 26 ↷3 und fixiert so schließlich die erreichte Einrastposition 20. Der Inkrementierungsablauf der Speicherzelle 12 ist damit wie in Figur 5e) gezeigt abgeschlossen.

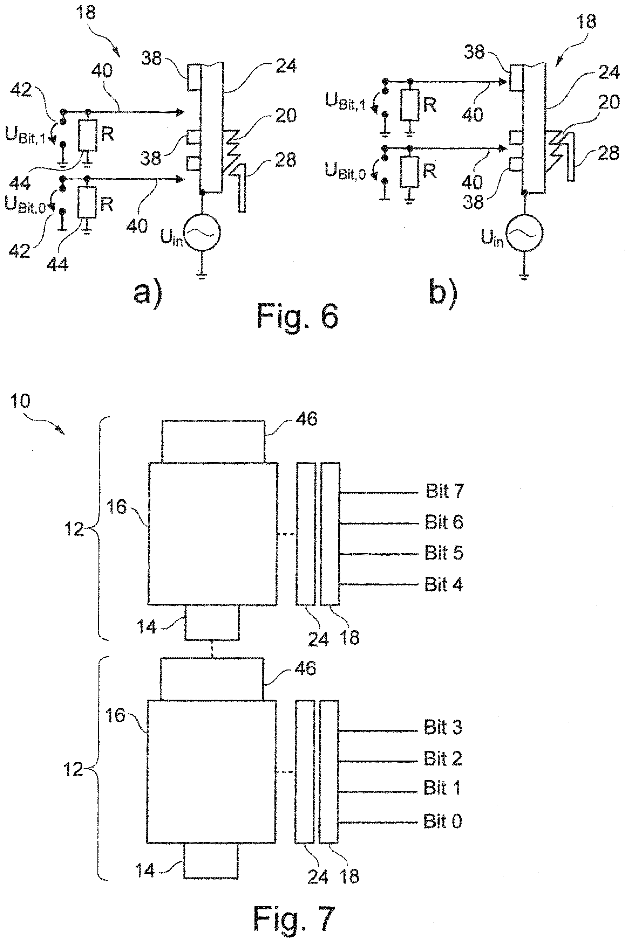

Figur 6 zeigt schematisch einen weiteren Ausschnitt aus der Speicherzelle 12 aus Figur 1, wobei hierbei insbesondere die elektromechanischen Codiereinheit 18 zu erkennen ist. Die Aufgabe der elektromechanischen Codiereinheit 18 besteht darin die diskrete Einrastposition 20 des Läufers 24 zu digitalisieren, also der jeweiligen diskreten Einrastposition 20 einen elektrischen binären Zahlencode zuzuordnen. Dafür weist der Läufer 24 eine geometrische Codierung in Form von spezifisch angeordneten Kontaktelektroden 38 auf, die als Schalter dienen. Je Bit, das codiert werden soll, wird ein Satz an Kontaktelektroden 18, auch als Bit-Zweige bezeichnet mit je mindestens einer zugehörigen Gegenelektrode 40 benötigt. Die Kontaktelektroden 38 weisen in diesem Ausführungsbeispiel eine fingerförmige Struktur auf. Gegenüber den Kontaktelektroden 38 am Läufer 24 befinden sich ortsfeste Abtastpunkte in Form der Gegenelektroden 40, die flexibel gelagert am Gestell des Zählers 10 angebracht sind. Die Gegenelektroden 40 sind in einem geringen oder überlappenden Abstand zu den Kontaktelektroden 38 am Läufer 24 montiert. Wird der Läufer 24 translatorisch in Laufrichtung verschoben, so stehen sich je nach Position jeweils eine Gegenelektrode 40 und eine Kontaktelektrode 38 oder eben keine Kontaktelektrode 38 gegenüber. Stehen sich eine Kontaktelektrode 38 und eine Gegenelektrode 40 gegenüber, so entspricht dies für das entsprechende Bit einer logischen Eins. Andernfalls liegt eine logische Null vor. In Figur 6a) ist der Läufer 24 im initialen Zustand, was einem Ausgangszustand des Rastmechanismus 16 entspricht und weist somit einen Zählerstand von 0 auf. Diesem Zählerstand wird über die elektromechanische Codiereinheit 18 der binären Zahlencode 00 zugeordnet, da sich beide Kontaktelektroden 38 nicht gegenüber einer Gegenelektrode 40 befinden. In Figur 6b) ist der Läufer 24 in der zweiten Einrastposition eingerastet und weist somit einen Zählerstand von 2 auf. Diesem Zählerstand wird über die elektromechanische Codiereinheit 18 der binären Zahlencode 10 zugeordnet, da sich die Kontaktelektroden 38 für die erste Stelle der binären Zahl, was der unteren Kontaktelektrode 38 entspricht nicht gegenüber einer Gegenelektrode 38 befinden (Zustand 0), und die obere Kontaktelektrode 38, die die zweite Stelle der binären Zahl codiert sich gegenüber einer Gegenelektrode 40 befindet (Zustand 1).

Zur elektrischen Auswertung wird an die elektromechanische Codiereinheit 18 zunächst eine elektrische Spannung angelegt. Über den Läufer 24 und damit die Kontaktelektrode 38 wird die Spannung je nach Position an die Gegenelektrode 40 übertragen. Dies ist sowohl über einen direkten mechanischen Kontakt zwischen Kontaktelektrode 38 und Gegenelektrode 40 möglich, wie in Figur 6 gezeigt, als auch im kontaktlosen Zustand. Das elektrische Signal gelangt dann in die elektrische Auswerteeinheit. Es wird eine parallele, nicht getaktete elektrische Auswertung realisiert. Alle Bitzustände können also gleichzeitig ausgelesen werden. Im hier gezeigten Ausführungsbeispiel wird das über die Gegenelektrode 40 übertragene Spannungssignal direkt ausgewertet, indem an jedem Spannungsabgriff 42 entsprechende Pullup- bzw. Pulldown- Widerstände 44 vorgesehen sind, sodass das Spannungspotential am jeweiligen Spannungsabgriff 42 in jeder Situation klar definiert ist.

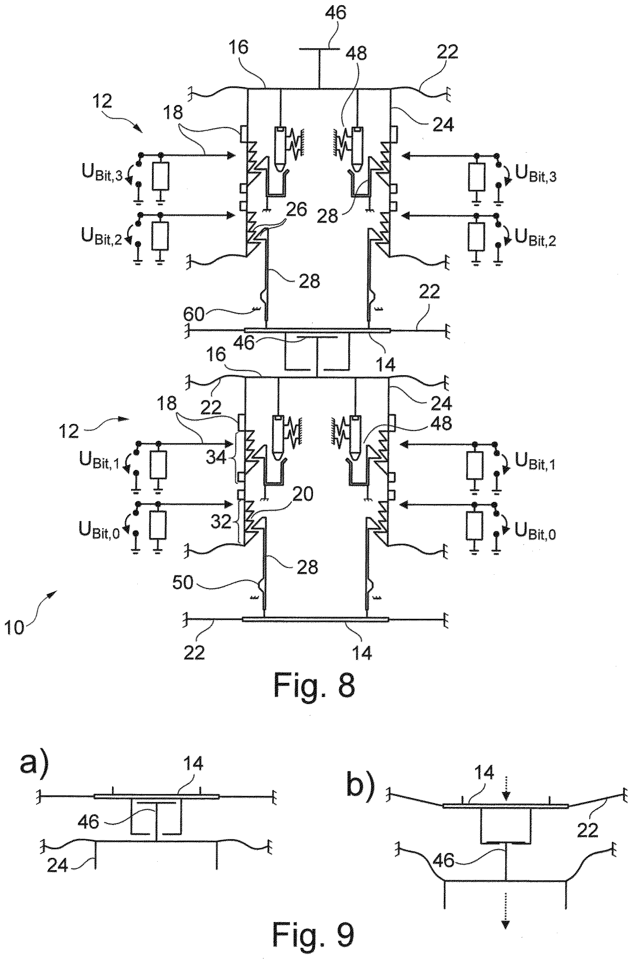

Figur 7 zeigt schematisch eine weitere Ausführungsform des Zählers 10, wobei der Zähler 10 in dieser Ausführungsform zwei Speicherzellen 12 umfasst. Figur 8 zeigt dazu eine detaillierte Ansicht der Ausführungsform aus Figur 7. Die Speicherzellen 12 umfassen wie in der ersten Ausführungsform in Figur 1 den Zelleingang 14, den Rastmechanismus 16 und die elektromechanische Codiereinheit 18. Des Weiteren umfassen die Speicherzellen jeweils einen Überträger 46 und einen Rückstellmechanismus 48 (nur in Figur 8 zu erkennen). In diesem Ausführungsbeispiel sind die zwei Speicherzellen 12 seriell über den Überträger 46 miteinander verschaltet. Dabei verbindet der Überträger 46 den Ausgang der ersten Speicherzelle 12 mit dem Zelleneingang 14 der zweiten seriell angeordneten Speicherzelle 12. Der abgebildete Zähler 10 in Figur 7 weist eine Speicherkapazität von 8 Bit auf, wobei jede Speicherzelle 12 eine Speicherkapazität von je 4 Bit aufweist. Der Zähler in Figur 8 weist eine Speicherkapazität von 4 Bit auf, wobei jede Speicherzelle 12 eine Speicherkapazität von je 2 Bit aufweist.

Der Überträger 46 ist des Weiteren in Figur 9 gezeigt. Der Überträger 46 ist dazu ausgeführt, bei Erreichen der Speicherkapazität der Speicherzelle 12 den mechanischen Impuls an den Zelleingang 14 der seriell verschalteten weiteren Speicherzelle 12 zu übertragen. In der gezeigten Ausführungsform umfasst der Überträger 46 ein formschlüssiges Element in Form eines T. Sobald der Läufer 24 der ersten Speicherzelle 12 die letztmögliche diskrete Einrastposition 20 und damit den letztmöglichen Speicherwert erreicht hat, kommt zu einer mechanischen Verbindung zwischen dem T-förmigen formschlüssigen Element und dem Zelleneingang 14 der seriell verbundenen Speicherzelle 12 (siehe Figur 9b). Wirkt nun ein weiterer mechanischer Impuls am Zelleingang 14 der ersten Speicherzelle 12, so wird über die mechanische Verbindung der mechanische Impuls direkt an die nächste Speicherzelle 12 weitergeleitet.

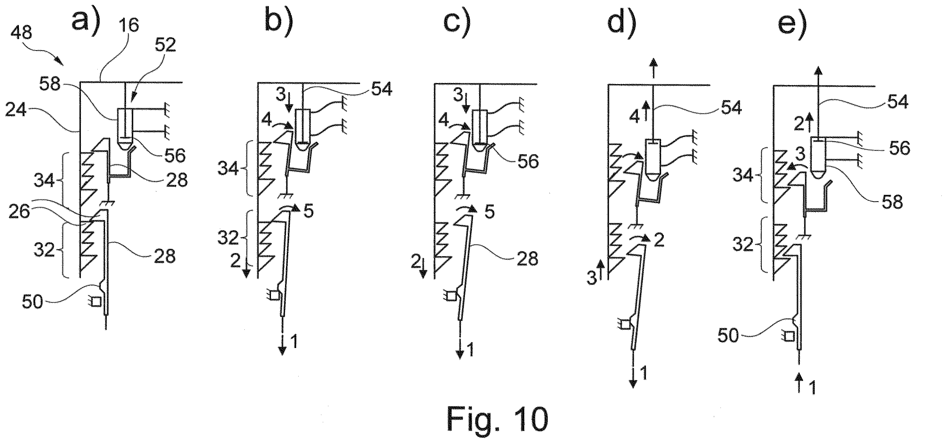

Figur 10 zeigt das Funktionsprinzip des Rückstellmechanismus 48. Der Rückstellmechanismus 48 ist dazu ausgeführt bei Erreichen der Speicherkapazität der Speicherzelle 12 durch den mechanischen Impuls die diskrete Einrastposition 20 des Rastmechanismus 16 derart zu verändern, dass sie dem Ausgangszustand entspricht. Dies wird vom Rückstellmechanismus 48 realisiert, indem er nach Erreichen der letzten diskreten Einrastposition 20 des Rastmechanismus 16 die Fixierung zwischen den Rastzähnen 26 des Läufers 24 und der Gegenraste 28 löst, sodass sich der Läufer 24 über die Rückstellkraft der Führungsfedern 22 in seinen Ausgangszustand bewegen kann. Der Rückstellmechanismus 48 teilt sich auf zwei Funktionsgruppen auf. Eine davon sorgt dafür, dass die Verbindung zwischen den Rastzähnen 26 am Inkrementierer 32 bei einer bestimmten Auslenkung geöffnet wird, der zweite Teil sorgt für die Öffnung des Haltemechanismus 34. Am Inkrementierer 32 befinden sich hierzu zwei Stößel 50. Ein Stößel 50 befindet sich über das Gestell federgelagert an einer ortsfesten Position, der andere befindet sich an der Gegenraste 28 des Inkrementierers 32. Sobald der Zelleneingang 14 und damit die Gegenraste 28 über eine kritische Strecke hinaus ausgelenkt wird, drückt der Stößel 50 die Verbindung zwischen Gegenraste 28 und Rastzahn 26 auf, sodass die Verbindung am Inkrementierer 32 gelöst wird. Die Verbindung des Haltemechanismus 34 wird mit Hilfe einer Verriegelungseinheit 52 geöffnet und bis zum vollständigen Zurücksetzen der Speicherzelle 12 offen gehalten. Im Ausführungsbeispiel ist der letzte Rastzahn 26 im Gegensatz zu den anderen Rastzähnen 26 dafür ausgeführt eine besonders lockere mechanische Verbindung mit der Gegenraste 28 einzugehen. Die formschlüssigen Verbindungen zwischen Gegenrasten 28 und den anderen Rastzähnen sind hingegen derart robust ausgeführt, dass sie durch den Stößel 50 daher nicht aufgedrückt werden können. Vielmehr wird in diesem Fall der federgelagerte Stößels 50 kurzfristig über die Feder ausgelenkt.

Figur 10 stellt den prinzipiellen Ablauf beim Zurücksetzen der Speicherzelle 12 dar: In Figur 10a) wird zunächst der Rastmechanismus 16 der Speicherzelle 12 gezeigt, die bereits ihre maximale Speicherkapazität erreicht hat. Wird nun eine weitere direkte Inkrementierung durchgeführt (Figur 10b), so wird zunächst die Gegenraste 28 und damit der Läufer 24 in negative x-Richtung ausgelenkt ↓1, ↓2. Gleichzeitig wird in der Verriegelungseinheit 52 über einen Schieber 54 der Schieberiegel 56 in den Riegelhalter 58 geschoben ↓3. Darüber wird die Gegenraste 28 des Haltemechanismus 34 geöffnet ↷4. Wird, wie in Figur 10c) gezeigt, der Zelleneingang 14 noch weiter ausgelenkt, so wird die Gegenraste 28 am Inkrementierer 32 über den Stößel 50 ausgelenkt ↷5 und öffnet so die mechanische Verbindung zum Läufer 24. Der Läufer 24 ist damit nicht mehr fixiert, weder über den Haltemechanismus 34 noch über den Inkrementierer 32. Schließlich wird der Läufer 24 aufgrund der Rückstellkräfte der Führungfedern 22 (in Figur 10 nicht dargestellt) wieder in x-Richtung gezogen (Figur 10d) ↑3. Sobald der Läufer 24 seine Endposition erreicht, wird über den Schieber 54 die Verriegelung der Gegenraste 28 des Haltemechanismus 34 wieder gelöst ↑4, so dass wie in Figur 10e) gezeigt die Gegenraste 28 des Haltemechanismus 34 wieder einrastet ↶3.

### Bezugszeichenliste

- 10: passiver mikromechanischer Zähler
- 12: Speicherzelle
- 14: Zelleingang
- 16: Rastmechanismus
- 18: elektromechanische Codiereinheit
- 20: diskrete Einrastposition
- 22: Festkörperführung, Festkörpergelenk, Führungsfeder
- 24: Läufer
- 26: Rastzahn
- 28: Gegenraste
- 30: Biegefeder
- 32: Inkrementierer
- 34: Haltemechanismus
- 36: Greifer
- 38: Kontaktelektrode
- 40: Gegenelektrode
- 42: Spannungsabgriff
- 44: Pullup- und Pulldown Widerstand
- 46: Überträger
- 48: Rückstellmechanismus
- 50: Stößel
- 52: Verriegelungseinheit
- 54: Schieber
- 56: Schieberiegel
- 58: Riegelhalter
- 60: Stopper

## Patentansprüche

1. Passiver mikromechanischer Zähler (10) zum Zählen und Speichern einer Anzahl an mechanischen Impulsen umfassend wenigstens eine Speicherzelle (12),
wobei die Speicherzelle (12) einen Zelleingang (14), einen Rastmechanismus (16) und eine elektromechanische Codiereinheit (18) umfasst,
wobei der Zelleingang (14) dazu ausgeführt ist, den mechanischen Impuls mechanisch an den Rastmechanismus (16) zu übertragen,
wobei der Rastmechanismus (16) dazu ausgeführt ist, die Anzahl übertragener mechanischer Impulse mittels seiner diskreten Einrastposition (20) zu speichern,
**dadurch gekennzeichnet, dass**
durch Anlegen einer elektrischen Spannung an die elektromechanische Codiereinheit (18) ein elektrisches digitales Signal erzeugbar ist, wobei das elektrische digitale Signal die diskrete Einrastposition (20) des Rastmechanismus (16) repräsentiert.

2. Passiver mikromechanischer Zähler (10) nach Anspruch 1 **dadurch gekennzeichnet, dass** der Zelleingang (14) dazu ausgeführt ist, den mechanischen Impuls in Form einer translatorischen oder rotatorischen Bewegung an den Rastmechanismus (16) zu übertragen.

3. Passiver mikromechanischer Zähler (10) nach einem der vorangehenden Ansprüche **dadurch gekennzeichnet, dass** der Rastmechanismus (16) dazu ausgeführt ist bei jedem vom Zelleingang (16) übertragenen mechanischen Impuls seine diskrete Einrastposition (20) zu verändern.

4. Passiver mikromechanischer Zähler (10) nach Anspruch 3 **dadurch gekennzeichnet, dass** der passive mikromechanische Zähler (10) derart ausgestaltet ist, dass eine Kraft zum Verändern der diskreten Einrastposition (20) unabhängig von der diskreten Einrastposition (20) ist.

5. Passiver mikromechanischer Zähler (10) nach einem der vorangehenden Ansprüche **dadurch gekennzeichnet, dass** die Anzahl diskreter Einrastpositionen (20) des Rastmechanismus (16) eine Speicherkapazität der Speicherzelle definiert.

6. Passiver mikromechanischer Zähler (10) nach einem der vorangehenden Ansprüche **dadurch gekennzeichnet, dass** der Rastmechanismus (16) einen Läufer (24) oder einen Rotor, sowie eine Gegenraste (28) umfasst, wobei der Läufer (24) oder der Rotor mittels Rastzähnen (26) an der Gegenraste (28) in der diskreten Einrastposition (20) einrastbar sind.

7. Passiver mikromechanischer Zähler (10) nach Anspruch 6 **dadurch gekennzeichnet, dass** der Rastmechanismus (16) einen Haltemechanismus (34) umfasst, der derart ausgestaltet ist, dass der Läufer (24) nur entlang einer axialen Richtung verschiebbar ist, oder dass der Rotor nur entlang einer Drehrichtung drehbar ist.

8. Passiver mikromechanischer Zähler (10) nach einem der vorangehenden Ansprüche **dadurch gekennzeichnet, dass** die elektromechanische Codiereinheit (18) Kontaktelektroden (38) und Gegenelektroden (40) umfasst, wobei die diskrete Einrastposition (20) des Rastmechanismus (16) mittels der räumlichen Anordnung der Kontaktelektroden (38) zu den Gegenelektroden (40) ermittelbar ist.

9. Passiver mikromechanischer Zähler (10) nach einem der vorangehenden Ansprüche **dadurch gekennzeichnet, dass** die Speicherzelle (12) zusätzlich einen Überträger (46) und einen Rückstellmechanismus (48) umfasst.

10. Passiver mikromechanischer Zähler (10) nach einem der vorangehenden Ansprüche **dadurch gekennzeichnet, dass** der Zähler (10) wenigstens zwei miteinander seriell verschaltete Speicherzellen (12) umfasst, wobei die Speicherzelle (12) jeweils zusätzlich einen Überträger (46) und einen Rückstellmechanismus (48) umfasst.

11. Passiver mikromechanischer Zähler (10) nach Anspruch 10 **dadurch gekennzeichnet, dass** eine Gesamtspeicherkapazität des Zählers (10) dem Produkt der einzelnen Speicherkapazitäten der seriell verschalteten Speicherzellen (12) entspricht.

12. Passiver mikromechanischer Zähler (10) nach Anspruch 10 oder 11, **dadurch gekennzeichnet, dass** der Überträger (46) dazu ausgeführt ist, bei Erreichen der Speicherkapazität der Speicherzelle (12) den mechanischen Impuls an den Zelleingang (14) der seriell verschalteten weiteren Speicherzelle (14) zu übertragen.

13. Passiver mikromechanischer Zähler (10) nach einem der Ansprüche 11 oder 12, **dadurch gekennzeichnet, dass** der Rückstellmechanismus (48) dazu ausgeführt ist, bei Erreichen der Speicherkapazität der Speicherzelle (12) durch den mechanischen Impuls die diskrete Einrastposition (20) des Rastmechanismus (16) derart zu verändern, dass sie einem Ausgangszustand entspricht.

## Claims

1. Passive micromechanical counter (10) for counting and storing a number of mechanical pulses comprising at least one memory cell (12),
wherein the memory cell (12) comprises a cell input (14), a latching mechanism (16) and an electromechanical coding unit (18),
wherein the cell input (14) is adapted to mechanically transmit the mechanical pulse to the latching mechanism (16),
wherein the latching mechanism (16) is adapted to store the number of transmitted mechanical pulses by means of its discrete latching position (20),
**characterized in that**
an electrical digital signal can be generated by applying an electrical voltage to the electromechanical coding unit (18), wherein the electrical digital signal represents the discrete latching position (20) of the latching mechanism (16).

2. Passive micromechanical counter (10) according to claim 1, **characterized in that** the cell input (14) is configured to transmit the mechanical pulse to the latching mechanism (16) in the form of a translational or rotational movement.

3. Passive micromechanical counter (10) according to any one of the preceding claims, **characterized in that** the latching mechanism (16) is configured to change its discrete latching position (20) for each mechanical pulse transmitted from the cell input (14).

4. Passive micromechanical counter (10) according to claim 3, **characterized in that** the passive micromechanical counter (10) is configured in such a way that a force for changing the discrete latching position (20) is independent of the discrete latching position (20).

5. Passive micromechanical counter (10) according to any one of the preceding claims, **characterized in that** the number of discrete latching positions (20) of the latching mechanism (16) defines a storage capacity of the memory cell.

6. Passive micromechanical counter (10) according to any one of the preceding claims, **characterized in that** the latching mechanism (16) comprises a slider (24) or a rotor, as well as a counter latch (28), wherein the slider (24) or the rotor can be latched in the discrete latching position (20) by means of latching teeth (26) on the counter latch (28).

7. Passive micromechanical counter (10) according to claim 6, **characterized in that** the latching mechanism (16) comprises a holding mechanism (34) which is configured in such a way that the slider (24) can only be displaced along an axial direction, or that the rotor can only be rotated along a direction of rotation.

8. Passive micromechanical counter (10) according to any one of the preceding claims, **characterized in that** the electromechanical coding unit (18) comprises contact electrodes (38) and counter electrodes (40), wherein the discrete latching position (20) of the latching mechanism (16) can be determined by means of the spatial arrangement of the contact electrodes (38) relative to the counter electrodes (40).

9. Passive micromechanical counter (10) according to any one of the preceding claims, **characterized in that** the memory cell (12) additionally comprises a transmitter (46) and a reset mechanism (48).

10. Passive micromechanical counter (10) according to any one of the preceding claims, **characterized in that** the counter (10) comprises at least two memory cells (12) connected in series with one another, wherein each memory cell (12) additionally comprises a transmitter (46) and a reset mechanism (48).

11. Passive micromechanical counter (10) according to claim 10, **characterized in that** a total storage capacity of the counter (10) corresponds to the product of the individual storage capacities of the serially interconnected memory cells (12).

12. Passive micromechanical counter (10) according to claim 10 or 11, **characterized in that** the transmitter (46) is configured to transmit the mechanical pulse to the cell input (14) of the serially connected further memory cell (14) when the storage capacity of the memory cell (12) is reached.

13. Passive micromechanical counter (10) according to claim 11 or 12, **characterized in that** the reset mechanism (48) is configured to change the discrete latching position (20) of the latching mechanism (16) by the mechanical pulse such that it corresponds to an initial state, when the storage capacity of the memory cell (12) is reached.

## Revendications

1. Compteur micromécanique passif (10) pour compter et stocker un certain nombre d'impulsions mécaniques, comprenant au moins une cellule mémoire (12),
dans lequel la cellule mémoire (12) comprend une entrée de cellule (14), un mécanisme de verrouillage (16) et une unité de codage électromécanique (18),
dans lequel l'entrée de cellule (14) est conçue pour transmettre mécaniquement l'impulsion mécanique au mécanisme de verrouillage (16),
dans lequel le mécanisme de verrouillage (16) est conçu pour stocker le nombre d'impulsions mécaniques transmises au moyen de sa position de verrouillage discrète (20),
**caractérisé en ce que**
un signal numérique électrique peut être généré en appliquant une tension électrique à l'unité de codage électromécanique (18), le signal numérique électrique représentant la position de verrouillage discrète (20) du mécanisme de verrouillage (16).

2. Compteur micromécanique passif (10) selon la revendication 1, **caractérisé en ce que** l'entrée de cellule (14) est conçue pour transmettre l'impulsion mécanique au mécanisme de verrouillage (16) sous la forme d'un mouvement de translation ou de rotation.

3. Compteur micromécanique passif (10) selon l'une quelconque des revendications précédentes, **caractérisé en ce que** le mécanisme de verrouillage (16) est conçu pour changer sa position de verrouillage discrète (20) à chaque impulsion mécanique transmise depuis l'entrée de cellule (16).

4. Compteur micromécanique passif (10) selon la revendication 3, **caractérisé en ce que** le compteur micromécanique passif (10) est arrangé de sorte qu'une force pour changer la position de verrouillage discrète (20) soit indépendante de la position de verrouillage discrète (20).

5. Compteur micromécanique passif (10) selon l'une quelconque des revendications précédentes, **caractérisé en ce que** le nombre de positions de verrouillage discrètes (20) du mécanisme de verrouillage (16) définit une capacité de stockage de la cellule mémoire.

6. Compteur micromécanique passif (10) selon l'une quelconque des revendications précédentes, **caractérisé en ce que** le mécanisme de verrouillage (16) comprend un élément capable de se déplacer (24) ou un rotor, ainsi qu'une contre-détente (28), l'élément capable de se déplacer (24) ou le rotor pouvant être verrouillé sur la contre-détente (28) dans la position de verrouillage discrète (20) au moyen de dents de verrouillage (26).

7. Compteur micromécanique passif (10) selon la revendication 6, **caractérisé en ce que** le mécanisme de verrouillage (16) comprend un mécanisme de maintien (34) qui est conçu de telle sorte que l'élément capable de se déplacer (24) ne peut être déplacé que dans une direction axiale ou que le rotor ne peut être tourné que le long d'une direction de rotation.

8. Compteur micromécanique passif (10) selon l'une quelconque des revendications précédentes, **caractérisé en ce que** l'unité de codage électromécanique (18) comprend des électrodes de contact (38) et des contre-électrodes (40), la position d'enclenchement discrète (20) du mécanisme d'enclenchement (16) peut être déterminée au moyen de la disposition spatiale des électrodes de contact (38) par rapport aux contre-électrodes (40).

9. Compteur micromécanique passif (10) selon l'une quelconque des revendications précédentes, **caractérisé en ce que** la cellule mémoire (12) comprend en outre un émetteur (46) et un mécanisme de réinitialisation (48).

10. Compteur micromécanique passif (10) selon l'une quelconque des revendications précédentes, **caractérisé en ce que** le compteur (10) comprend au moins deux cellules mémoire (12) connectées en série, les cellules mémoires (12) comportant respectivement en plus un émetteur (46) et un mécanisme de réinitialisation (48).

11. Compteur micromécanique passif (10) selon la revendication 10, **caractérisé en ce qu'**une capacité de stockage totale du compteur (10) correspond au produit des capacités de stockage individuelles des cellules mémoire connectées en série (12).

12. Compteur micromécanique passif (10) selon la revendication 10 ou la revendication 11, **caractérisé en ce que** l'émetteur (46) est conçu pour, lorsque la capacité de stockage de la cellule mémoire (12) est atteinte, transmettre l'impulsion mécanique à l'entrée de cellule (14) de l'autre cellule mémoire connectée en série (12).

13. Compteur micromécanique passif (10) selon la revendication 11 ou la revendication 12, **caractérisé en ce que** le mécanisme de réinitialisation (48) est conçu pour, lorsque la capacité de stockage de la cellule mémoire (12) est atteinte, changer la position de verrouillage discrète (20) du mécanisme de verrouillage (16) par l'impulsion mécanique de telle manière qu'elle corresponde à un état initial.
